Europäisches Patentamt

European Patent Office

Office européen des brevets

(11) Publication number: **0 226 613 B1**

# EUROPEAN PATENT SPECIFICATION

(45) Date of publication of patent specification: **15.09.93**  (51) Int. Cl.⁵: **H03G 3/34**

(21) Application number: **86903767.1**

(22) Date of filing: **05.05.86**

(86) International application number:
**PCT/US86/00990**

(87) International publication number:
**WO 87/00366 (15.01.87 87/01)**

(54) **NOISE SUPRESSION SYSTEM.**

(30) Priority: **01.07.85 US 750572**
**01.07.85 US 750941**
**01.07.85 US 750942**

(43) Date of publication of application:
**01.07.87 Bulletin 87/27**

(45) Publication of the grant of the patent:
**15.09.93 Bulletin 93/37**

(84) Designated Contracting States:
**DE FR GB IT NL SE**

(56) References cited:
US-A- 3 989 897      US-A- 4 135 590
US-A- 4 185 168      US-A- 4 208 548
US-A- 4 340 778      US-A- 4 363 006
US-A- 4 363 007

(73) Proprietor: **MOTOROLA, INC.**
**1303 East Algonquin Road**
**Schaumburg, IL 60196(US)**

(72) Inventor: **BORTH, David, Edward**
**825 South Harvard Drive**
**Palatine, IL 60067(US)**
Inventor: **GERSON, Ira, Alan**
**1120 Nottingham Lane**
**Hoffman Estates, IL 60195(US)**
Inventor: **VILMUR, Richard, Joseph**
**45 South Kerwood Street**
**Palatine, IL 60067(US)**
Inventor: **SMANSKI, Philip, Jerome**
**1734 Emerald Lane**
**Palatine, IL 60074(US)**

(74) Representative: **Ibbotson, Harold et al**
**Motorola Ltd Patent and Licensing Operations - Europe Jays Close Viables Industrial Estate**
**Basingstoke Hampshire RG22 4PD (GB)**

THE BELL SYSTEM TECHNICAL JOURNAL, vol. 60, no. 8, October 1981, pages 1847-1859, American Telephone and Telegraph Co., New York, US; M.M. SONDHI et al.: "Improving the quality of a noisy speech signal"

ICASSP 80 PROCEEDINGS, IEEE INTERNATIONAL CONFERENCE ON ACOUSTICS, SPEECH AND SIGNAL PROCESSING, 9th-11th April 1980, Denver, Colorado, vol. 3, pages 699-702, IEEE, New York, US; R.J. McAULAY et al.: "A real-time noise suppression filter for speech enhancement and robust channel vocoding"

**Description**

Background of the Invention

1. Field of the Invention

The present invention relates generally to acoustic noise suppression systems, and, more particularly, to an improved method and means for suppressing environmental background noise from speech signals to obtain speech quality enhancement.

2. Description of the Prior Art

Acoustic noise suppression systems generally serve the purpose of improving the overall quality of the desired signal by distinguishing the signal from the ambient background noise. More specifically, in speech communications systems, it is highly desirable to improve the signal-to-noise ratio (SNR) of the voice signal to enhance the quality of speech. This speech enhancement process is particularly necessary in environments having abnormally high levels of ambient background noise, such as an aircraft, a moving vehicle, or a noisy factory.

A typical application for noise suppression is in a hearing aid. Environmental background noise is not only annoying to the hearing-impaired, but often interferes with their ability to understand speech. One method of addressing this problem may be found in U.S. Patent No. 4,461,025, entitled "Automatic Background Noise Suppressor." According to this approach, the speech signal is enhanced by automatically suppressing the audio signal in the absence of speech, and increasing the audio system gain when speech is present. This variation of an automatic gain control (AGC) circuit examines the incoming audio waveform itself to determine if the desired speech component is present.

A second method for enhancing the intelligiblity of speech in a hearing aid application is described in U.S. Patent No. 4,454,609. This technique emphasizes the spectral content of consonant sounds of speech to equalize the intensity of consonant sounds with that of vowel sounds. The estimated spectral shape of the input speech is used to modify the spectral shape of the actual speech signal so as to produce an enhanced output speech signal. For example, a control signal may select one of a plurality of different filters having particularized frequency responses for modifying the spectral shape of the input speech signal, thereby producing an enhanced consonant output signal.

A more sophisticated approach to a noise suppression system implementation is the spectral subtraction -- or spectral gain modification --technique. Using this approach, the audio input signal spectrum is divided into individual spectral bands by a bank of bandpass filters, and particular spectral bands are attenuated according to their noise energy content. A spectral subtraction noise suppression prefilter is described in R. J. McAulay and M. L. Malpass, "Speech Enhancement Using a Soft-Decision Noise Suppression Filter," IEEE Trans. Acoust., Speech, Signal Processing, vol. ASSP-28, no. 2, (April 1980), pp. 137-145. This prefilter utilizes an estimate of the background noise power spectral density to generate the speech SNR, which, in turn, is used to compute a gain factor for each individual channel. The gain factor is used as a pointer for a look-up table to determine the attenuation for that particular spectral band. The channels are then attenuated and recombined to produce the noise-suppressed output waveform.

However, in specialized applications involving relatively high background noise environments, a more effective noise suppression technique is being sought. For example, some cellular mobile radio telephone systems currently offer a vehicle speakerphone option providing hands-free operation for the automobile driver. The mobile hands-free microphone is typically located at a greater distance from the user, such as being mounted overhead on the visor. The more distant microphone delivers a much poorer signal-to-noise level to the land-end party due to road and wind noise within the vehicle. Although the received speech at the land end is usually intelligible, the high background noise level can be very annoying.

Although the aforementioned prior art techniques may perform sufficiently well under nominal background noise conditions, the performance of these approaches becomes severely limited when used under such high background noise conditions. Utilizing typical noise suppression systems, the noise level over most of the audio band can be reduced by 10 dB without seriously affecting the voice quality. However, when these prior art techniques are used in relatively high background noise environments requiring noise suppression levels approaching 20 dB, there is a substantial degradation in voice quality.

A need, therefore, exists for an improved acoustic noise suppression system which provides sufficient background noise attenuation in high ambient noise environments without significantly affecting the quality of the desired signal.

## Summary of the Invention

Accordingly, it is an object of the present invention to provide an improved system according to independent Claims 1 and 3 for suppressing background noise in high background noise environments.

Another object of the present invention is to provide an improved noise suppression system for speech communication which attains the optimum compromise between noise suppression depth and voice quality degradation.

A more particular object of the present invention is to provide a noise suppression system particularly adapted for use in hands-free cellular mobile radio telephone applications.

A further object of the present invention is to provide a low-cost acoustic noise suppression system capable of being implemented in an eight-bit microcomputer.

Briefly described, the present invention is an improved noise suppression system which performs speech quality enhancement by attenuating the background noise from a noisy pre-processed input signal -- the speech-plus-noise signal available at the input of the noise suppression system -- to produce a noise-suppressed post-processed output signal -- the speech-minus-noise signal provided at the output of the noise suppression system -- by spectral gain modification. The noise suppression system of the present invention includes a means for separating the input signal into a plurality of pre-processed signals representative of selected frequency channels, and a means for modifying an operating parameter, such as the gain, of each of these pre-processed signals according to a modification signal to provide post-processed noise-suppressed output signals. The means for generating the modification signal produces gain factors for each channel by automatically selecting one of a plurality of gain table sets in response to the overall average background noise level of the input signal, and by selecting one of a plurality of gain values from each gain table in response to the individual channel signal-to-noise ratio estimate. Thus, each individual channel gain value is selected as a function of (a) the channel number, (b) the current channel SNR estimate, and (c) the overall average background noise level. Accordingly, the noise suppression system of the present invention utilizes post-processed signal energy -- signal energy available at the output of the noise suppression system -- to generate a modification signal to control the noise suppression parameters. It is these techniques of implementing the post-processed signal to generate the modification signal, and automatically selecting one of a plurality of gain table sets per the average overall background noise level, that allows the present invention to perform acoustic noise suppression in high ambient noise backgrounds with significantly less voice quality degradation.

## Brief Description of the Drawings

The features of the present invention which are believed to be novel are set forth with particularity in the appended claims. The invention itself, however, together with further objects and advantages thereof, may best be understood by reference to the following description when taken in conjunction with the accompanying drawings, in which:

Figure 1 is a block diagram of a basic noise suppression system known in the art which illustrates the spectral gain modification technique;

Figure 2 is a block diagram of an alternate implementation of a prior art noise suppression system illustrating the channel filter-bank technique;

Figure 3 is a block diagram of an improved acoustic noise suppression system employing the background noise estimation technique of the present invention;

Figure 4 is a block diagram of an alternate implementation of the present invention utilizing simulated post-processed signal energy to generate the background noise estimate;

Figure 5 is a detailed block diagram illustrating the preferred embodiment of the improved noise suppression system according to the present invention;

Figure 6 is a flowchart illustrating the general sequence of operations performed in accordance with the practice of the present invention; and

Figure 7 is a detailed flowchart illustrating specific sequences of operations shown in Figure 6.

## Description of the Preferred Embodiment

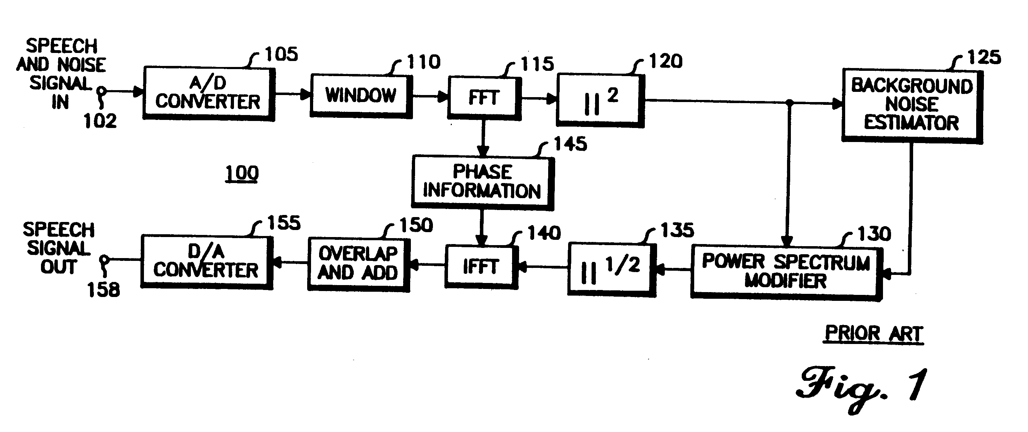

Referring now to the accompanying drawings, Figure 1 illustrates the general principle of spectral subtraction noise suppression as known in the art. A continuous time signal containing speech plus noise is applied to input 102 of noise suppression system 100. This signal is then converted to digital form by analog-to-digital converter 105. The digital data is then segmented into blocks of data by the windowing

4

operation (e.g., Hamming, Hanning, or Kaiser windowing techniques) performed by window 110. The choice of the window is similar to the choice of the filter response in an analog spectrum analysis. The noisy speech signal is then converted into the frequency domain by Fast Fourier Transform (FFT) 115. The power spectrum of the noisy speech signal is calculated by magnitude squaring operation 120, and applied to background noise estimator 125 and to power spectrum modifier 130.

The background noise estimator performs two functions: (1) it determines when the incoming speech-plus-noise signal contains only background noise; and (2) it updates the old background noise power spectral density estimate when only background noise is present. The current estimate of the background noise power spectrum is subtracted from the speech-plus-noise power spectrum by power spectrum modifier 130, which ideally leaves only the power spectrum of clean speech. The square root of the clean speech power spectrum is then calculated by magnitude square root operation 135. This magnitude of the clean speech signal is added to phase information 145 of the original signal, and converted from the frequency domain back into the time domain by Inverse Fast Fourier Transform (IFFT) 140. The discrete data segments off the clean speech signal are then applied to overlap-and-add operation 150 to reconstruct the processed signal. This digital signal is then re-converted by digital-to-analog converter 155 to an analog waveform available at output 158. Thus, an acoustic noise suppression system employing the spectral subtraction technique requires an accurate estimate of the current background noise power spectral density to perform the noise cancellation function.

One drawback of the Fourier Transform approach of Figure 1 is that it is a digital signal processing technique requiring considerable computational power to implement the noise suppression system in the frequency domain. Another disadvantage of the FFT approach is that the output signal is delayed by the time required to accumulate the samples for the FFT calculation.

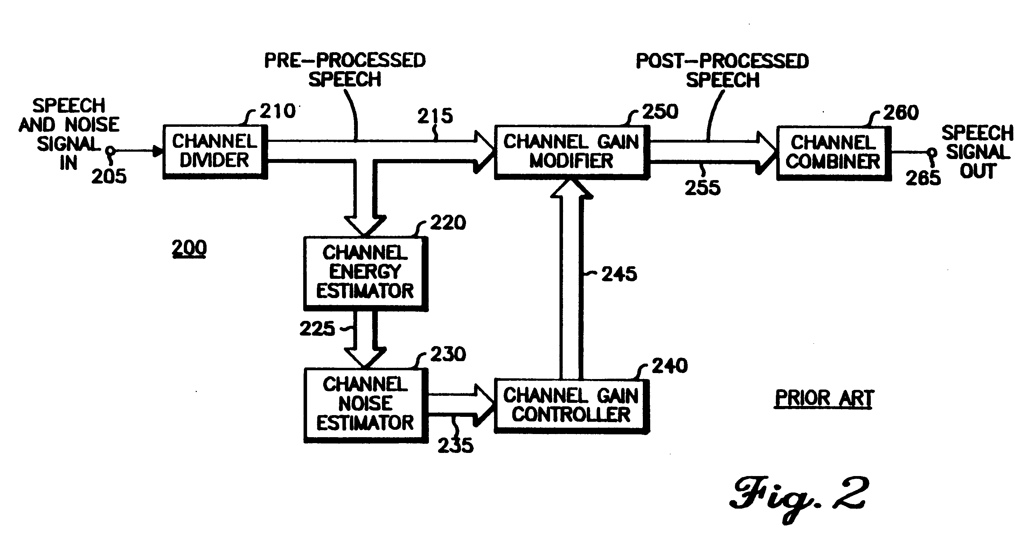

An alternate implementation of a spectral subtraction noise suppression system is the channel filter-bank technique illustrated in Figure 2. In noise suppression system 200, the speech-plus-noise signal available at input 205 is separated into a number of selected frequency channels by channel divider 210. The gain of these individual pre-processed speech channels 215 is then adjusted by channel gain modifier 250 in response to modification signal 245 such that the gain of the channels exhibiting a low speech-to-noise ratio is reduced. The individual channels comprising post-processed speech 255 are then recombined in channel combiner 260 to form the noise-suppressed speech signal available at output 265.

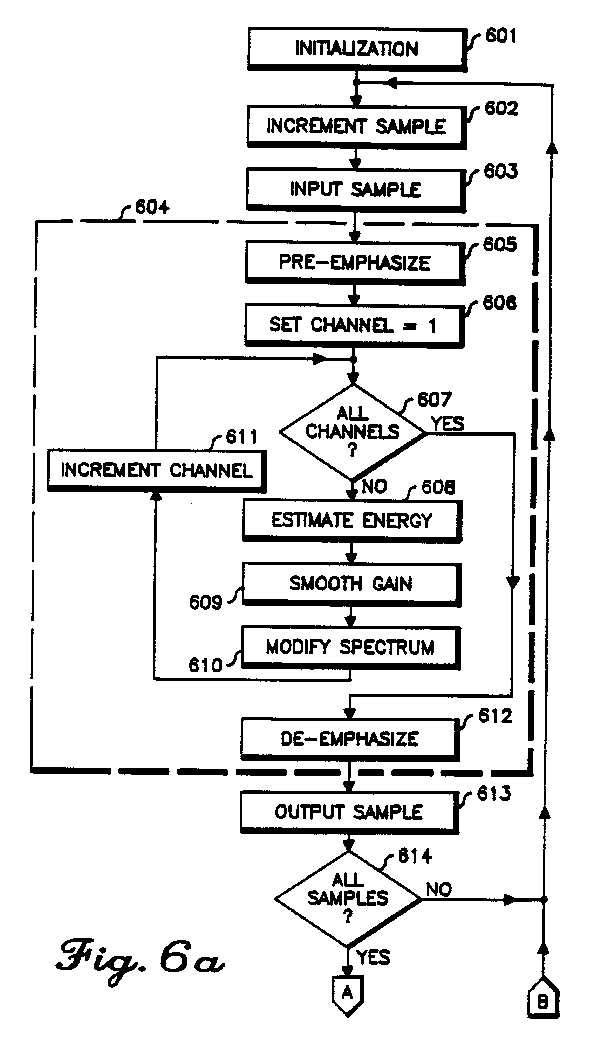

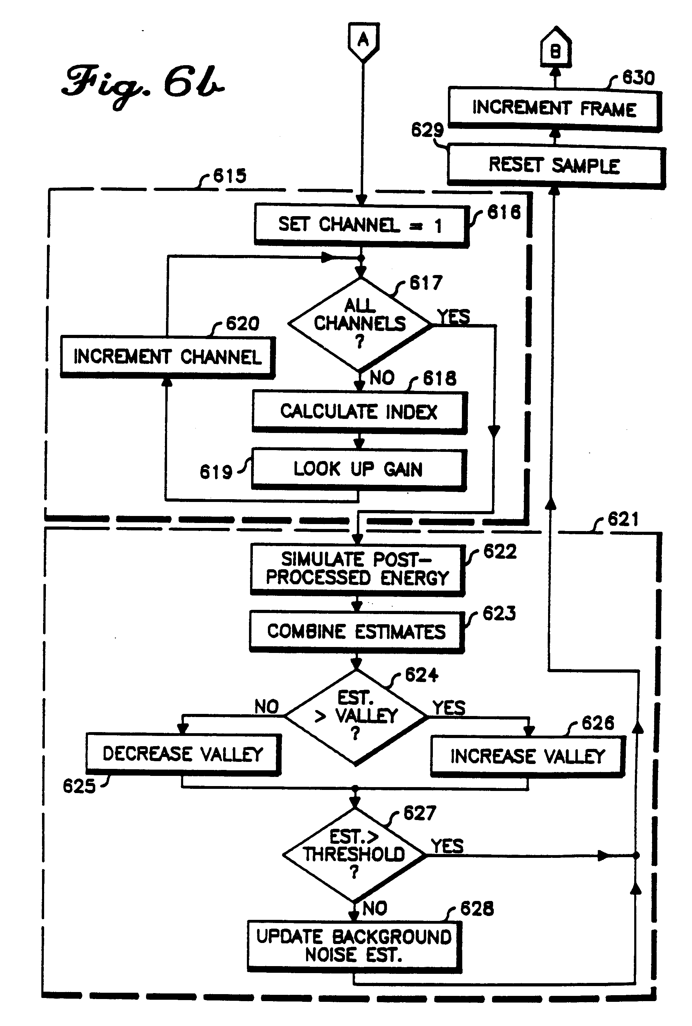

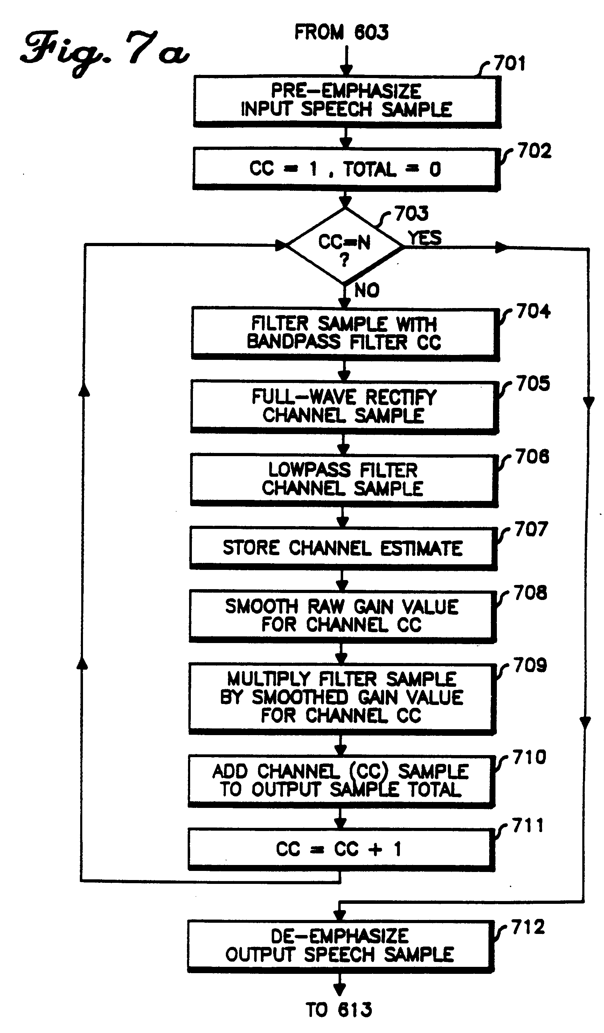

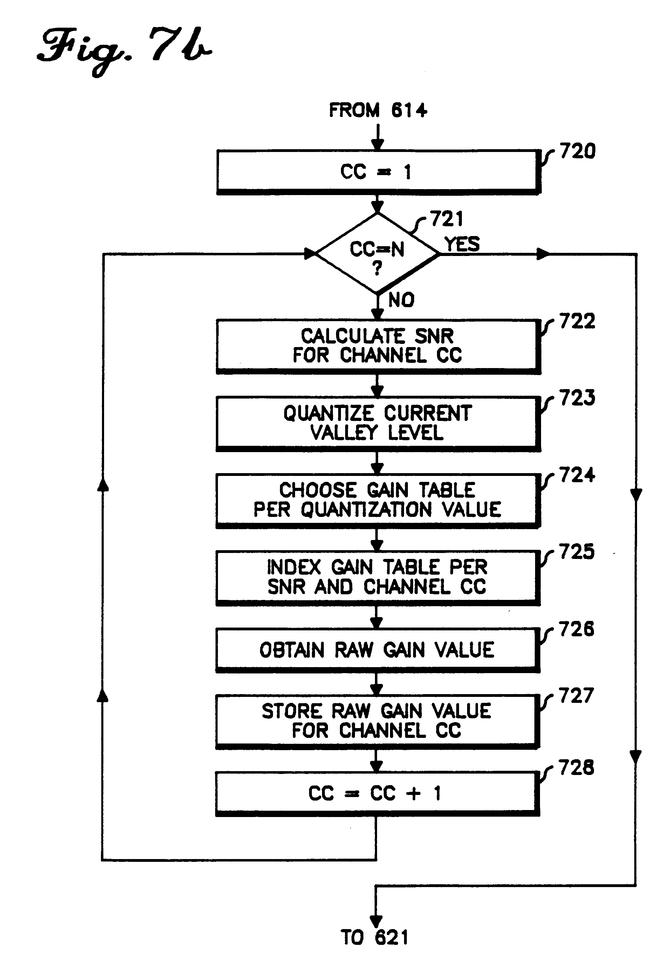

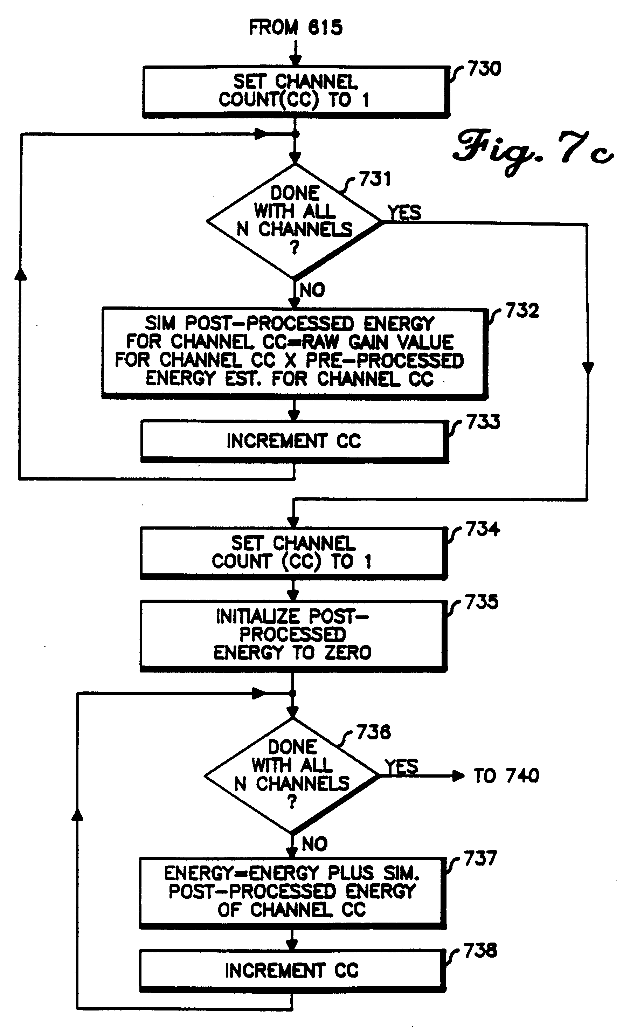

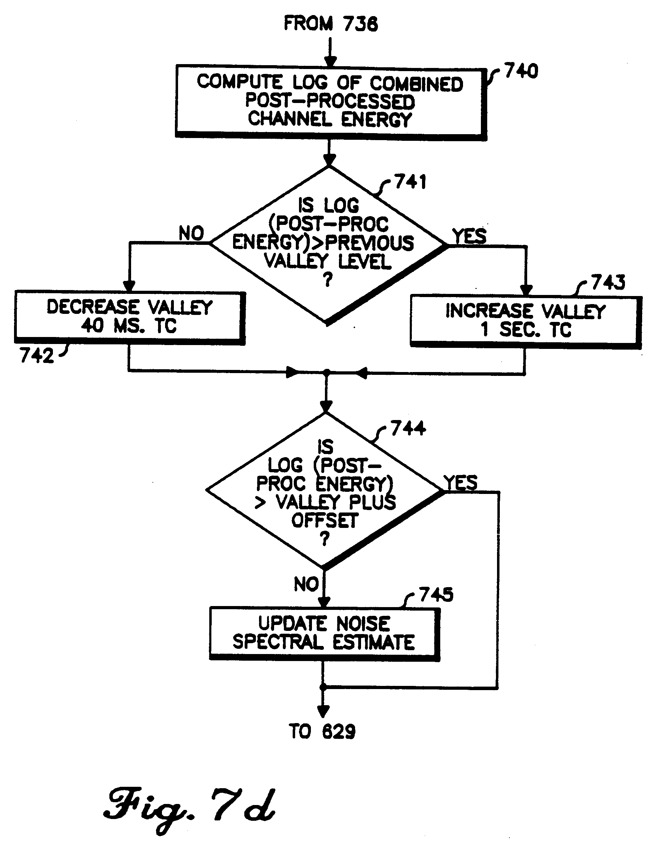

Channel divider 210 is typically comprised of a number N of contiguous bandpass filters. The filters overlap at the 3 dB points such that the reconstructed output signal exhibits less than 1 dB of ripple in the entire voice frequency range. In the present embodiment, 14 Butterworth bandpass filters are used to span the frequency range 250-3400 Hz., although any number and type of filters my be used. Also, in the preferred embodiment, the filter-bank of channel divider 210 is digitally implemented. This particular implementation will subsequently be described in Figures 6 and 7.

Channel gain modifier 250 serves to adjust the gain of each of the individual channels containing pre-processed speech 215. This modification is performed by multiplying the amplitude of the pre-processed input signal in a particular channel by its corresponding channel gain value obtained from modification signal 245. The channel gain modification function may readily be implemented in software utilizing digital signal processing (DSP) techniques.

Similarly, the summing function of channel combiner 260 may be implemented either in software, using DSP, or in hardware utilizing a summation circuit to combine the N post-processed channels into a single post-processed output signal. Hence, the channel filter-bank technique separates the noisy input signal into individual channels, attenuates those channels having a low speech-to-noise ratio, and recombines the individual channels to form a low-noise output signal.

The individual channels comprising pre-processed speech 215 are also applied to channel energy estimator 220 which serves to generate energy envelope values $E_1$-$E_N$ for each channel. These energy values, which comprise channel energy estimate 225, are utilized by channel noise estimator 230 to provide an SNR estimate $X_1$-$X_N$ for each channel. The SNR estimates 235 are then fed to channel gain controller 240 which provides the individual channel gain values $G_1$-$G_N$ comprising modification signal 245.

Channel energy estimator 220 is comprised of a set of N energy detectors to generate an estimate of the pre-processed signal energy in each of the N channels. Each energy detector may consist of a full-wave rectifier, followed by a second-order Butterworth low-pass filter, possibly followed by another full-wave rectifier. The preferred embodiment of the invention utilizes DSP implementation techniques in software, although numerous other approaches may be used. An appropriate DSP algorithm is described in Chapter 11 of L. R. Rabiner and B. Gold, Theory and Application of Digital Signal Processing, (Prentice Hall, Englewood Cliffs, N.J., 1975).

Channel noise estimator 230 generates SNR estimates $X_1$-$X_N$ by comparing the individual channel energy estimates of the current input signal energy (signal) to some type of current estimate of the background noise energy (noise). This background noise estimate may be generated by performing a channel energy measurement during the pauses in human speech. Thus, a background noise estimator continuously monitors the input speech signal to locate the pauses in speech such that the background noise energy can be measured during that precise time segment. A channel SNR estimator compares this background noise estimate to the input signal energy estimate to form signal-to-noise estimates on a per-channel basis. In the present embodiment, this SNR comparison is performed as a software division of the channel energy estimates by the background noise estimates on an individual channel basis.

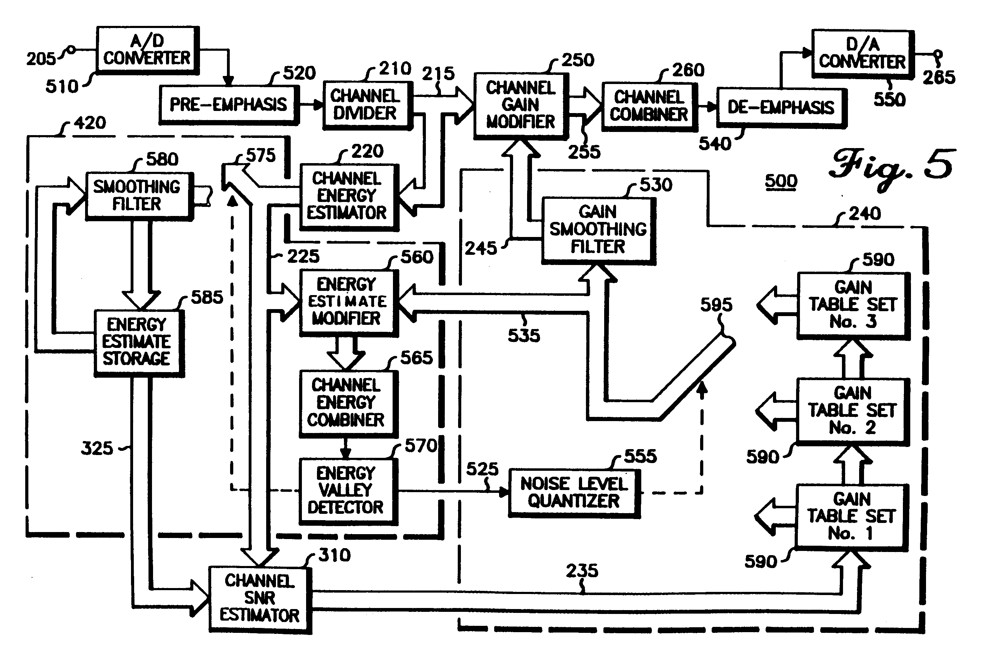

Channel gain controller 240 generates the individual channel gain values of the modification signal 245 in response to SNR estimates 235. One method of selecting gain values is to compare the SNR estimate with a preselected threshold, and to provide for unity gain when the SNR estimate is below the threshold, while providing an increased gain above the threshold. A second approach is to compute the gain value as a function of the SNR estimate such that the gain value corresponds to a particular mathematical relationship to the SNR (i.e., linear, logarithmic, etc.). The present embodiment uses a third approach, that of selecting the channel gain values from a channel gain table set comprised of empirically determined gain values. This approach will be fully described in conjunction with Figure 5.

As noted above, the background noise estimate may be generated by performing a measurement of the pre-processed signal energy during the pauses in human speech. Accordingly, the background noise estimator must accurately locate the pauses in speech by performing a speech/noise decision to control the time in which a background noise energy measurement is performed. Previous methods for making the speech/noise decision have heretofore been implemented by utilizing input signal energy -- the signal-plus-noise energy available at the input of the noise suppression system. This practice of using the input signal places inherent limitations upon the effectiveness of any background noise estimation technique. These limitations are due to the fact that the energy characteristics of unvoiced speech sounds are very similar to the energy characteristics of background noise. In a relatively high background noise environment, the speech/noise decision process becomes very difficult and, consequently, the background noise estimate becomes highly inaccurate. This inaccuracy directly affects the performance of the noise suppression system as a whole.

If, however, the speech/noise decision of the background noise estimate were based upon output signal energy -- the signal energy available at the output of the noise suppression system -- then the accuracy of the speech/noise decision process would be greatly enhanced by the noise suppression system itself. In other words, by utilizing post-processed speech -- the speech energy available at the output of the noise suppression system -- the background noise estimator operates on a much cleaner speech signal such that a more accurate speech/noise classification can be performed. The present invention teaches this unique concept of implementing post-processed speech signal to base these speech/noise decisions upon. Accordingly, more accurate determinations of the pauses in speech are made, and better performance of the noise suppressor is achieved.

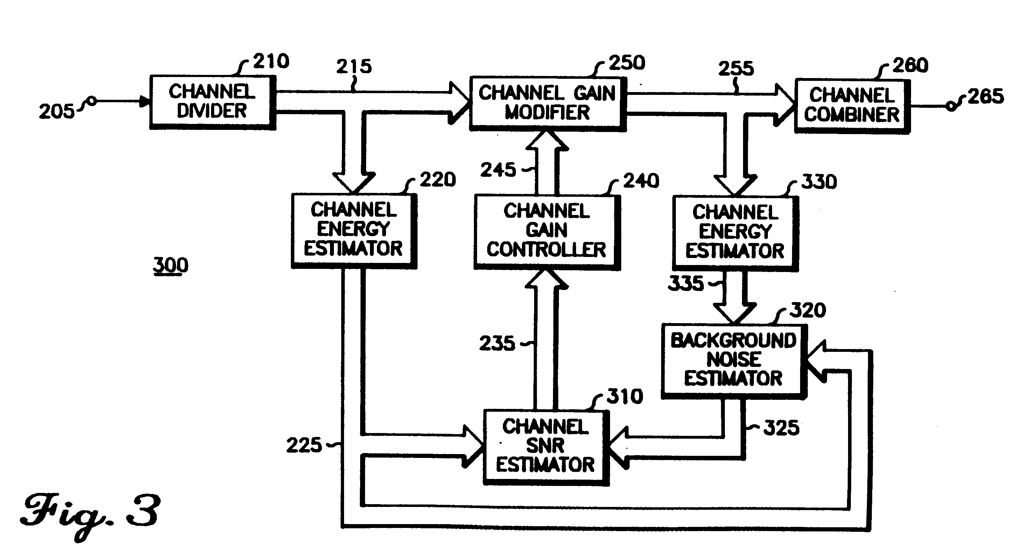

This novel technique of the present invention is illustrated in Figure 3, which shows a simplified block diagram of improved acoustic noise suppression system 300. Channel divider 210, channel gain modifier 250, channel combiner 260, channel gain controller 240, and channel energy estimator 220 remain unchanged from noise suppression system 200. However, channel noise estimator 230 of Figure 2 has been replaced by channel SNR estimator 310, background noise estimator 320, and channel energy estimator 330. In combination, these three elements generate SNR estimates 235 based upon both pre-processed speech 215 and post-processed speech 255.

Operation and construction of channel energy estimator 330 is identical to that of channel energy estimator 220, with the exception that post-processed speech 255, rather than pre-processed speech 215, is applied to its input. The post-processed channel energy estimates 335 are used by background noise estimator 320 to perform the speech/noise decision.

In generating background noise estimate 325, two basic functions must be performed. First, a determination must be made as to when the incoming speech-plus-noise signal contains only background noise -- during the pauses in human speech. This speech/noise decision is performed by periodically detecting the minima of post-processed speech signal 255, either on an individual channel basis or an overall combined-channel basis. Secondly, the speech/noise decision is utilized to control the time at which the background noise energy measurement is taken, thereby providing a mechanism to update the old background noise estimate. A background noise estimate is performed by generating and storing an estimate of the background noise energy of pre-processed speech 215 provided by pre-processed channel energy estimate 225. Numerous methods may be used to detect the minima of the post-processed signal

6

energy, or to generate and store the estimate of the background noise energy based upon the pre-processed signal. The particular approach used in the present embodiment for performing these functions will be described in conjunction with Figure 6.

Channel SNR estimator 310 compares background noise estimate 325 to channel energy estimates 225 to generate SNR estimates 235. As previously noted, this SNR comparison is performed in the present embodiment as a software division of the channel energy estimates (signal-plus-noise) by the background noise estimates (noise) on an individual channel basis. SNR estimates 235 are used to select particular gain values from a channel gain table comprised of empirically determined gains.

It is this method of more accurately controlling the time at which the background noise measurement is performed, by basing the time determination upon post-processed speech energy, that provides a more accurate measurement of the pre-processed speech for the background noise estimate. Consequently, the performance of the entire noise suppression system is improved by deriving the speech/noise decision from post-processed speech.

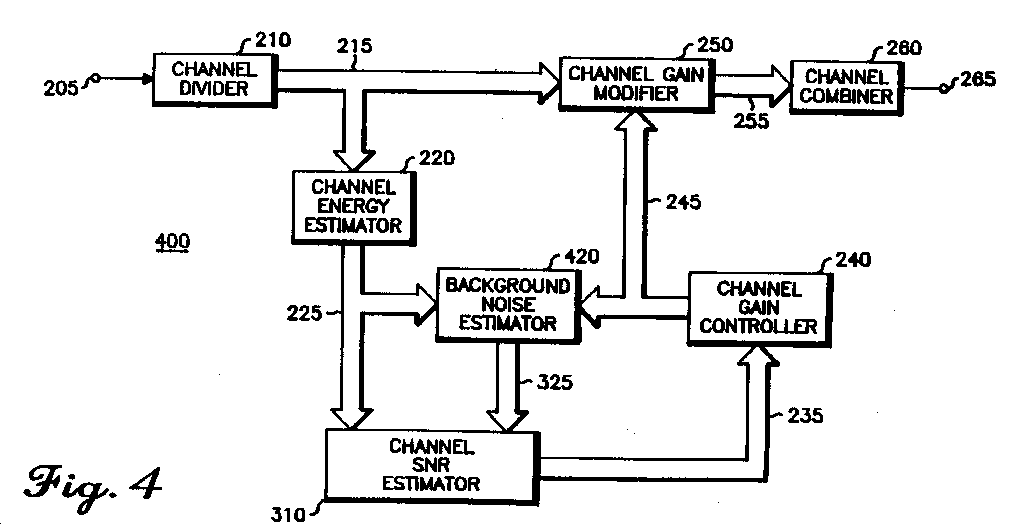

Figure 4 is an alternate implementation of the present invention illustrating how the post-processed speech energy, used by the background noise estimator, may be obtained in a different manner. Post-processed speech energy may be "simulated" by multiplying pre-processed channel energy estimates 225, obtained from channel energy estimator 220, by the channel gain values of modification signal 245, obtained from channel gain controller 240. This multiplication is performed on a per-channel basis in background noise estimator 420, thereby providing a plurality of background noise estimates 325 to channel SNR estimator 310. In the present embodiment, this multiplication process is performed by an energy estimate modifier incorporated in background noise estimator 420. Alternatively, this simulated post-processed speech may be provided by an external multiplication block, or by other modification means.

The advantage of providing simulated post-processed speech energy to the background noise estimator is that a second channel energy estimator (320) is no longer required. Channel energy estimator 220 provides pre-processed speech energy estimates 225 for each channel which, when multiplied by the individual channel gain factors, represent post-processed speech energy estimates 335 normally provided by post-processed channel energy estimator 330. Therefore, the function of one channel energy estimator block may be saved at the expense of some type of energy estimate modification block. Depending on the system configuration and implementation, the advantage of using simulated post-processed speech (provided by a modification block) versus post-processed speech (obtained directly from the output) may be significant.

Figure 5 is a detailed block diagram of the preferred embodiment of the present invention. Improved noise suppression system 500 incorporates numerous useful noise suppression techniques: (a) the channel filter-bank noise suppression technique illustrated in Figure 2; (b) the simulated post-processed speech energy technique for background noise estimation as shown in Figure 4; (c) the energy valley detector technique for performing the speech/noise decision; (d) a novel technique for selecting gain values from multiple gain tables according to overall background noise level; and (e) a new method of smoothing the gain factors on a per-sample basis.

Referring now to Figure 5, analog-to-digital converter 510 samples the noisy speech signal at input 205 every 125 microseconds. This digital signal is then applied to pre-emphasis filter 520 which provides approximately 6 dB per-octave pre-emphasis to the signal before it is separated into channels. Pre-emphasis is used because both high frequency noise and high frequency voice components are normally lower in energy level as compared to low frequency noise and voice. The pre-emphasized signal is then applied to channel divider 210, which separates the input signal into N signals representative of selected frequency channels. These N channels comprising pre-processed speech 215 are then applied to channel energy estimator 220 and channel gain modifier 250, as previously described. After gain modification, the individual channels comprising post-processed speech 255 are summed by channel combiner 260 to form a single post-processed output signal. This signal is then de-emphasized at approximately 6 dB per-octave by de-emphasis network 540 before being re-converted to an analog waveform by digital-to-analog converter 550. The noise-suppressed (clean) speech signal is then available at output 265.

The energy in each of the N channels is measured by channel energy estimator 220 to produce channel energy estimates 225. These energy envelope values are applied to three distinct blocks. First, the pre-processed signal energy estimates are multiplied by raw channel gain values 535 in energy estimate modifier 560. This multiplication serves to simulate post-processed energy by performing essentially the same function as channel gain modifier 250 -- except on a channel energy level rather than on a channel signal level. The individual simulated post-processed channel energy estimates from energy estimate modifier 560 are applied to channel energy combiner 565 which provides a single overall energy estimate for energy valley detector 570. Channel energy combiner 565 may be omitted if multiple valley detectors are utilized on a per-channel basis and the valley detector output signals are combined.

Energy valley detector 570 utilizes the overall energy estimate from combiner 565 to detect the pauses in speech. This is accomplished in three steps. First, an initial valley level is established. If background noise estimator 420 has not previously been initialized, then an initial valley level is created which would correspond to a high background noise environment. Otherwise, the previous valley level is maintained as its post-processed background noise energy history. Next, the previous (or initialized) valley level is updated to reflect current background noise conditions. This is accomplished by comparing the previous valley level to the single overall energy estimate from combiner 565. A current valley level is formed by this updating process, which will be described in detail in Figure 7. The third step performed by energy valley detector 570 is that of making the actual speech/noise decision. A preselected valley offset is added to the updated current valley level to produce a noise threshold level. Then the single overall post-processed energy estimate is again compared, only this time to the noise threshold level. When this energy estimate is less than the noise threshold level, energy valley detector 570 generates a speech/noise control signal (valley detect signal) indicating that no voice is present.

The second use for pre-processed energy estimates 225 is that of updating the background noise estimate. During the pauses in the simulated post-processed speech signal, as determined by a positive valley detect signal from energy valley detector 570, channel switch 575 is closed to allow pre-processed speech energy estimates 225 to be applied to smoothing filter 580. The smoothed energy estimates at the output of smoothing filter 580 are stored in energy estimate storage register 585. Elements 580 and 585, connected as shown, form a recursive filter which provide a time-averaged value of each individual speech energy estimate. This smoothing ensures that the current background noise estimates reflect the average background noise estimates stored in storage register 585, as opposed to the instantaneous noise energy estimates available at the output of switch 575. Thus, a very accurate background noise estimate 325 is continuously available for use by the noise suppression system.

If no previous background noise estimate exists in energy estimate storage register 585, the register is preset with an initialization value representing a background noise estimate approximating that of a low noise input.

Initially, no noise suppression is being performed. As a result, energy valley detector 570 is performing speech/noise decisions on speech energy which has not yet been processed. Eventually, valley detector 570 provides rough speech/noise decisions to activate channel switch 575, which causes the initialized background noise estimate to be updated. As the background noise estimate is updated, the noise suppressor begins to process the input speech energy by suppressing the background noise. Consequently, the post-processed speech energy exhibits a slightly greater signal-to-noise ratio for the valley detector to utilize in making more accurate speech/noise classifications. After the system has been in operation for a short period of time (e.g., 100-500 milliseconds), the valley detector is operating on an improved SNR speech signal. Thus, reliable speech/noise decisions control switch 575, which, in turn, permit energy estimate storage register 585 to very accurately reflect the background noise power spectrum. It is this "bootstrapping technique" --updating the initialization values with more accurate background noise estimates -- that allows the present invention to generate very accurate background noise estimates for an acoustic noise suppression system.

The third use for pre-processed channel energy estimates 225 is for application to channel SNR estimator 310. As previously noted, these estimates represent signal-plus-noise for comparison to background noise estimate 325, representing noise only. This signal-to-noise comparison is performed as a software division in channel SNR estimator 310 to produce channel SNR estimates 235. These SNR estimates are used to select particular channel gain values comprising modification signal 245.

Gain tables generally provide nonlinear mapping between the channel SNR inputs $X_1$-$X_N$ and the channel gain outputs $G_1$-$G_N$. A gain table is basically a two-dimensional array of empirically-determined gain values. These channel gain values are typically selected as a function of two variables: (a) the individual channel number N; and (b) the individual SNR estimate $X_N$. When voice is present in an individual channel, the channel signal-to-noise ratio estimate will be high. A large SNR estimate $X_N$ would result in a channel gain value $G_N$ approaching a maximum value (i.e., 1 in the present embodiment). The amount of the gain rise may be designed to be dependent upon the detected SNR -- the greater the SNR, the more the individual channel gain will be raised from the base gain (all noise). If only noise is present in the individual channel, the SNR estimate will be low, and the gain for that channel will be reduced, approaching a minimum base gain value (i.e., 0 ). Voice energy does not appear in all of the channels at the same time, so the channels containing a low voice energy level will be suppressed from the voice energy spectrum.

However, in unusually high background noise environments requiring noise suppression levels of approximately 20 dB, different noise suppression gain factors must be chosen to correspond to such levels.

Furthermore, in certain applications exhibiting changing noise environments, the gain factors chosen for one background noise level may significantly degrade the voice quality when used with a different background noise level. This problem is particularly evident in automobile environments where inappropriate gain factors can cause a loss of low frequency voice components, which makes voices sound "thin" under high noise suppression.

The present embodiment solves this problem by selecting the channel gain values as a function of three variables by channel gain controller 240. The first variable is that of individual channel number 1 through N, such that a low frequency channel gain factor may be selected independently from that of a high frequency channel. The second variable is the individual channel SNR estimate. These two variables perform the basis of spectral gain modification noise suppression, since the individual channels containing a low signal-to-noise ratio estimate will be suppressed from the voice spectrum.

The third variable is that of overall average background noise level of the input signal. This third variable permits automatic selection of one of a plurality of gain tables, each gain table containing a set of empirically determined channel gain values which can be selected as a function of the other two variables. This gain table selection technique allows a wider choice of channel gain values, depending on the particular background noise environment. For example, a separate gain table set with different nonlinear relationships between the low frequency and high frequency gain values may be desired in a particular background noise environment, allowing the noise-suppressed speech to sound more normal. This technique is particularly useful in automobile environments, where a loss of low frequency voice components makes voices sound thin under high noise suppression.

Again referring to Figure 5, the overall average background noise level is determined by applying the current valley level 525 from energy valley detector 570 to noise level quantizer 555. The output of quantizer 555 is used to select the appropriate gain table set for the given noise environment. Noise level quantization is required since the current valley level is a continuously varying parameter, whereas only a discrete number of gain table sets are available from which to choose gain values. Noise level quantizer 555 utilizes hysteresis to determine a particular gain table set from a range of current valley levels, as opposed to a static (strictly linear) threshold selection mechanism.

The gain table selection signal, output from noise level quantizer 555, is applied to gain table switch 595 to implement the gain table selection process. Accordingly, one of a plurality of gain table sets 590 may be chosen as a function of overall average background noise level. Each gain table set has selected individual channel gain values corresponding to various individual channel SNR estimates 235. In the present embodiment, three gain table sets are utilized, representing low, medium, or high background noise levels. However, any number of gain table sets may be used and any organization of channel gain values may be implemented.

The raw channel gain values 535, available at the output of switch 595, are applied to gain smoothing filter 530 and to energy estimate modifier 560. As noted above, these raw gain values are used by energy estimate modifier 560 to produce simulated post-processed speech energy estimates.

Gain smoothing filter 530 provides smoothing of raw gain values 535 on a per-sample basis for each individual channel. This per-sample smoothing of the noise suppression gain factors significantly improves noise flutter performance caused by step discontinuities in frame-to-frame gain changes. Different time constants for each channel are used to compensate for the different gain table sets employed. The gain smoothing filter algorithm will be described later. These smoothed gain values comprise modification signal 245 which is applied to channel gain modifier 250. As previously described, the channel gain modifier performs spectral gain modification noise suppression by reducing the relative gain of the noisy channels.

Figure 6a/b is a flowchart illustrating the overall operation of the present invention. The flowchart of Figure 6a/b corresponds to improved noise suppression system 500 of Figure 5. This generalized flow diagram is subdivided into three functional blocks: noise suppression loop 604 -- further described in detail in Figure 7a; automatic gain selector 615 -- described in more detail in Figure 7b; and automatic background noise estimator 621 -- illustrated in Figures 7c and 7d.

The operation of the improved noise suppression system of the present invention begins with Figure 6a at initialization block 601. When the system is first powered-up, no old background noise estimate exists in energy estimate storage register 585, and no noise energy history exists in energy valley detector 570. Consequently, during initialization 601, storage register 585 is preset with an initialization value representing a background noise estimate value corresponding to a clean speech signal at the input. Similarly, energy valley detector 570 is preset with an initialization value representing a valley level corresponding to a noisy speech signal at the input.

Initialization block 601 also provides initial sample counts, channel counts, and frame counts. For the purposes of the following discussion, a sample period is defined as 125 microseconds corresponding to an 8 KHz sampling rate. The frame period is defined as being a 10 millisecond duration time interval to which the input signal samples are quantized. Thus, a frame corresponds to 80 samples at an 8 KHz sampling rate.

Initially, the sample count is set to zero. Block 602 increments the sample count by one, and a noisy speech sample is input from A/D converter 510 in block 603. The speech sample is then pre-emphasized by pre-emphasis network 520 in block 605.

Following pre-emphasis, block 606 initializes the channel count to one. Decision block 607 then tests the channel count number. If the channel count is less than the highest channel number N, the sample for that channel is bandpass filtered, and the signal energy for that channel is estimated in block 608. The result is saved for later use. Block 609 smoothes the raw channel gain for the present channel, and block 610 modifies the level of the bandpass-filtered sample utilizing the smoothed channel gain. The N channels are then combined (also in block 610) to form a single processed output speech sample. Block 611 increments the channel count by one and the procedure in blocks 607 through 611 is repeated.

If the result of the decision in 607 is true, the combined sample is de-emphasized in block 612 and output as a modified speech sample in block 613. The sample count is then tested in block 614 to see if all samples in the current frame have been processed. If samples remain, the loop consisting of blocks 602 through 613 is re-entered for another sample. If all samples in the current frame have been processed, block 614 initiates the procedure of block 615 for updating the individual channel gains.

Continuing with Figure 6b, block 616 initiates the channel counter to one. Block 617 tests if all channels have been processed. If this decision is negative, block 618 calculates the index to the gain table for the particular channel by forming an SNR estimate. This index is then utilized in block 619 to obtain a channel gain value from the look-up table. The gain value is then stored for use in noise suppression loop 604. Block 620 then increments the channel counter, and block 617 rechecks to see if all channel gains have been updated. If this decision is affirmative, the background noise estimate is then updated in block 621.

To update the background noise estimate, the present invention first simulates post-processed energy in block 622 by multiplying the updated raw channel gain value by the pre-processed energy estimate for that channel. Next, the simulated post-processed energy estimates are combined in block 623 to form an overall channel energy estimate for use by the valley detector. Block 624 compares the value of this overall post-processed energy estimate to the previous valley level. If the energy value exceeds the previous valley level, the previous valley level is updated in block 626 by increasing the level with a slow time constant. This occurs when voice, or a higher background noise level, is present. If the output of decision block 624 is negative (post-processed energy less than previous valley level), the previous valley level is updated in block 625 by decreasing the level with a fast time constant. This previous valley level decrease occurs when minimal background noise is present. Accordingly, the background noise history is continually updated by slowly increasing or rapidly decreasing the previous valley level towards the current post-processed energy estimate.

Subsequent to the updating of the previous valley level (block 625 or 626), decision block 627 tests if the current post-processed energy value exceeds a predetermined noise threshold. If the result of this comparison is negative, a decision that only noise is present is made, and the background noise spectral estimate is updated in block 628. This corresponds to the closing of channel switch 575. If the result of the test is affirmative, indicating that speech is present, the background noise estimate is not updated. In either case, the operation of background noise estimator 621 ends when the sample count is reset in block 629 and the frame count is incremented in block 630. Operation then proceeds to block 602 to begin noise suppression on the next frame of speech.

The flowchart of Figure 7a illustrates the specific details of the sequence of operation of noise suppression loop 604. For every sample of input speech, block 701 pre-emphasizes the sample by implementing the filter described by the equation:

$$Y(nT) = X(nT) - K_1[X((n-1)T)]$$

where $Y(nT)$ is the output of the filter at time $nT$, $T$ is the sample period, $X(nT)$ and $X((n-1)T)$ are the input samples at times $nT$ and $(n-1)T$ respectively, and the pre-emphasis coefficient $K_1$ is 0.9375. As previously noted, this filter pre-emphasizes the speech sample at approximately +6 dB per-octave.

Block 702 sets the channel count equal to one, and initializes the output sample total to zero. Block 703 tests to see if the channel count is equal to the total number of channels N. If this decision is negative, the noise suppression loop begins by filtering the speech sample through the bandpass filter corresponding to the present channel count. As noted earlier, the bandpass filters are digitally implemented using DSP techniques such that they function as 4-pole Butterworth bandpass filters.

10

The speech sample output from bandpass filter(cc) is then full-wave rectified in block 705, and low-pass filtered in block 706, to obtain the energy envelope value $E_{(cc)}$ for this particular sample. This channel energy estimate is then stored by block 707 for later use. As will be apparent to those skilled in the art, energy envelope value $E_{(cc)}$ is actually an estimate of the square root of the energy in the channel.

Block 708 obtains the raw gain value RG for channel cc and performs gain smoothing by means of a first order IIR filter, implementing the equation:

$$G(nT) = G((n-1)T) + K_2(cc)(RG(nT)-G(n-1)T)$$

where G(nT) is the smoothed channel gain at time nT, T is the sample period, G((n-1)T) is the smoothed channel gain at time (n-1)T, RG(nT) is the computed raw channel gain for the last frame period, and $K_2(cc)$ is the filter coefficient for channel cc. This smoothing of the raw gain values on a per-sample basis reduces the discontinuities in gain changes, thereby significantly improving noise flutter performance.

Block 709 multiplies the filtered sample obtained in block 704 by the smoothed gain value for channel cc obtained from block 708. This operation modifies the level of the bandpass filtered sample using the current channel gain, corresponding to the operation of channel gain modifier 250. Block 710 then adds the modified filter sample for channel cc to the output sample total, which, when performed N times, combines the N modified bandpass filter outputs to form a single processed speech sample output. The operation of block 710 corresponds to channel combiner 260. Block 711 increments the channel count by one and the procedure in blocks 703 through 711 is then repeated.

If the result of the test in 703 is true, the output speech sample is de-emphasized at approximately -6 dB per-octave in block 712 according to the equation:

$$Y(nT) = X(nT) + K_3[Y((n-1)T)]$$

where X(nT) is the processed sample at time nT, T is the sample period, Y(nT) and Y((n-1)T) are the de-emphasized speech samples at times nT and (n-1)T respectively, and $K_3$ is the de-emphasis coefficient which hag a value of 0.9375. The de-emphasized processed speech sample is then output to the D/A converter block 613. Thus, the noise suppression loop of Figure 7a illustrates both the channel filter-bank noise suppression technique and the per-sample channel gain smoothing technique.

The flowchart of Figure 7b more rigorously describes the detailed operation of automatic gain selector block 615 of Figure 6. Following processing of all speech samples in a particular frame, the operation is turned over to block 615 which serves to update the individual channel gains. First of all, the channel count (cc) is set to one in block 720. Next, decision block 721 tests if all channels have been processed. If not, operation proceeds with block 722 which calculates the signal-to-noise ratio for the particular channel. As previously mentioned, the SNR calculation is simply a division of the per-channel energy estimates (signal-plus-noise) by the per-channel background noise estimates (noise). Therefore, block 722 simply divides the current stored channel energy estimate from block 707 by the current background noise estimate from block 628 according to the equation:

Index (cc) = [current frame energy for channel cc] / [background noise estimate for channel cc].

The current valley level, 525 of Figure 5, is then quantized in block 723 to produce a digital gain table selection signal from an analog valley level. Hysteresis is used in quantizing the valley level, since the gain table selection signal should not be responsive to minimal changes in current valley level.

In block 724, the particular gain table to be indexed is chosen. In the present embodiment, the quantized value of the current valley level generated in block 723 is used to perform this selection. However, any method of gain table selection may be used.

The SNR index calculated in block 722 is used in block 725 to look up the raw channel gain value from the appropriate gain table. Hence, the gain value is indexed as a function of three variables: (1) the channel number; (2) the current channel SNR estimate; and (3) the overall average background noise level. The raw gain value is then obtained in block 726 according to this three-variable index.

Block 727 stores the raw gain value obtained in block 726. Block 728 then increments the channel count, and decision block 721 is re-entered. After all N channel gains have been updated, operation proceeds to block 621 to update the current valley level and the current background noise estimate. Hence, automatic gain selector block 615 updates the channel gain values on a frame-by-frame basis as a function of the overall average background noise level to more accurately generate noise suppression gain factors for each particular channel.

Figure 7c and Figure 7d expands upon block 721 to more specifically describe the function of automatic background noise estimator 420 of Figure 5. Particularly, Figure 7c describes the process of simulating the post-processed energy and combining these estimates, while Figure 7d describes the operation of valley detector 570.

Referring now to Figure 7c, the operation for simulating post-processed speech begins at block 730 by setting the channel count (cc) to one. Block 731 tests this channel count to see if all N channels have been processed. If not, the equation of block 732 describes the actual simulation process performed by energy estimate modifier 560 of Figure 5.

Simulated post-processed speech energy is generated by multiplying the raw channel gain values (obtained directly from the channel gain tables) by the pre-processed energy estimate (obtained from channel energy estimator 220) for each channel via the equation:

$$SE(cc) = E(cc)\ RG(cc)$$

where SE(cc) is the simulated post-processed energy for channel cc, E(cc) is the current frame energy estimate for channel cc stored by block 707, and RG(cc) is the raw channel gain value for channel cc obtained from block 725. As noted earlier, E(cc) is actually the square root of the energy in the channel since it is a measure of the signal envelope. Hence, the RG(cc) term of the above equation is not squared. The multiplication performed in block 732 serves essentially the same function as channel gain modifier 250 -- except that the channel gain modifier utilizes pre-processed speech signal whereas energy estimate modifier 560 utilizes pre-processed speech energy. (See Figure 5).

The channel counter is then incremented in block 733, and retested in block 731. When a simulated post-processed energy value is obtained for all N channels, blocks 734 through 738 serve to combine the individual simulated channel energy estimates to form the single overall energy estimate according to the equation:

$$\textbf{POST-PROCESSED ENERGY} = \sum_{i=1}^{N} \textbf{CHANNEL(i) POST-PROCESSED ENERGY}$$

where N is the number of filters in the filter-bank.

Block 734 initializes the channel count to one, and block 735 initializes the overall post-processed energy value to zero. After initialization, decision block 736 tests whether or not all channel energies have been combined. If not, block 737 adds the simulated post-processed energy value for the current channel to the overall post-processed energy value. The current channel number is then incremented in block 738, and the channel number is again tested at block 736. When all N channels have been combined to form the overall simulated post-processed energy estimate, operation proceeds to block 740 of Figure 7d.

Referring now to Figure 7d, blocks 740 through 745 illustrate how the post-processed signal energy is used to generate and update the previous valley level, corresponding to the operation of energy valley detector 570 of Figure 5. After all the post-processed energies per channel have been combined, block 740 computes the logarithm of this combined post-processed channel energy. One reason that the log representation of the post-processed speech energy is used in the present embodiment is to facilitate implementation of an extremely large dynamic range (> 90dB) signal in an 8-bit microprocessor system.

Decision block 741 then tests to see if this log energy value exceeds the previous valley level. As previously mentioned, the previous valley level is either the stored valley level for the prior frame or an initialized valley level provided by block 701 of Figure 6. If the log value exceeds the previous valley level, the previous valley level is updated in block 743 with the current log [post-processed energy] value by increasing the level with the slow time constant of approximately one second to form a current valley level. This occurs when voice or a higher background noise level is present. Conversely, if the output of decision block 741 is negative (log [post-processed energy] less than previous valley level), the previous valley level is updated in block 742 with the current log [post-processed energy] value by decreasing the level with a fast time constant of approximately 40 milliseconds to form the current valley level. This occurs when a lower background noise level is present. Accordingly, the background noise history is continuously updated by slowly increasing or rapidly decreasing the previous valley level, depending upon the background noise level of the current simulated post-processed speech energy estimate.

After updating the previous valley level, decision block 744 tests if the current log [post-processed energy] value exceeds the current valley level plus a predetermined offset. The addition of the current valley level plus this valley offset produces a noise threshold level. In the present embodiment, this offset provides approximately a 6 dB increase to the current valley level. Hence, another reason for utilizing log arithmetic is to simplify the constant 6 dB offset addition process.

If the log energy exceeds this threshold -- which would correspond to a frame of speech rather than background noise -- the current background noise estimate is not updated, and the background noise updating process terminates. If, however, the log energy does not exceed the noise threshold level -- which would correspond to a detected minima in the post-processed signal indicating that only noise is present -- the background noise spectral estimate is updated in block 745. This corresponds to the closing of channel switch 575 in response to a positive valley detect signal from energy valley detector 570. This updating process consists of providing a time-averaged value of the pre-processed channel energy estimate for the particular channel by smoothing the estimate (in smoothing filter 580), and storing these time-averaged values as per-channel noise estimates (in energy estimate storage register 585). The operation of background noise estimator block 721 ends for the particular frame being processed by proceeding to block 729 and 630 to obtain a new frame.

In summary, the present invention performs spectral subtraction noise suppression by utilizing post-processed speech signal to generate the background noise estimate. The present invention further improves the performance of these systems by utilizing overall average background noise to generate the noise suppression gain factors, and by smoothing these gain factors on a per-sample basis. These novel techniques allow the present invention to improve acoustic noise suppression performance in high ambient noise backgrounds without degrading the quality of the desired speech signal.

While specific embodiments of the present invention have been shown and described herein, further modifications and improvements may be made by those skilled in the art. All such modifications which retain the basic underlying principles disclosed and claimed herein are within the scope of this invention.

## Claims

1. An improved noise suppression system (400) for attenuating the background noise from a noisy input signal (205) to produce a noise-suppressed output signal (265), said noise suppression system having

   means (210) for separating the input signal into a plurality of pre-processed signals (215) representative of selected frequency channels,

   means (250) for modifying the gain of each of said plurality of pre-processed signals in response to a predetermined gain value (245) to provide a plurality of post-processed signals (255),

   means (260) for combining said plurality of post-processed signals to produce said noise-suppressed output signal, and

   means (240, 310, 420) for producing said predetermined gain value, said noise suppression system characterized in that:

   said predetermined gain value (245) is produced in response to estimates of the signal-to-noise ratio (SNR) in each individual channel (235); and

   said SNR estimates in each individual channel are based upon the current signal energy estimate of the pre-processed signal in each individual channel (225) and the previous noise energy estimate of the pre-processed signal in each individual channel (325) determined at moments corresponding to the detected minima of a representation of said plurality of post-processed signals.

2. The improved noise suppression system according to claim 1, wherein said means for producing said predetermined gain value includes:

   a plurality of gain tables (590), each gain table having predetermined individual channel gain values corresponding to various individual channel SNR estimates; and

   gain table selection means (555, 595) for automatically selecting one of said plurality of gain tables according to the overall average background noise level of said input signal.

3. An improved noise suppression system (500) for attenuating the background noise from a noisy pre-processed input signal (205) to produce a noise-suppressed post-processed output signal (265) by spectral gain modification, said noise suppression system comprising:

   signal dividing means (210) for separating the pre-processed input signal into a plurality of selected frequency bands, thereby producing a plurality of pre-processed channels (215);

   channel energy estimation means (220) for generating an estimate (225) of the energy in each of

13

said plurality of pre-processed channels;

background noise estimation means (420) for generating and storing estimates (325) of the background noise energy based upon said channel energy estimates, and for periodically detecting the minima of the post-processed signal energy level such that said background noise estimates are updated only during said minima;

channel SNR estimation means (310) for generating an estimate of the signal-to-noise ratio (SNR) of each individual channel (235) based upon said channel energy estimates and said background noise estimates;

channel gain controlling means (240) for providing channel gain values (245) corresponding to said channel SNR estimates;

channel gain modifying means (250) for adjusting the gain of each of said plurality of pre-processed channels provided by said signal dividing means according to said channel gain values, thereby producing a plurality of post-processed channels (255); and

channel combination means (260) for recombining said plurality of post-processed channels to produce said post-processed output signal.

4. The improved noise suppression system according to claim 3, wherein said background noise estimation means (420) includes means (560) for generating said representation of the post-processed signal energy level by multiplying said plurality of pre-processed channels by said channel gain values.

5. The improved noise suppression system according to claim 3, wherein said background noise estimation means (420) includes:

storage means (580, 585) for storing an estimate of the background noise energy of the pre-processed signal in each of said plurality of selected frequency bands as per-channel noise estimates, and for continuously providing said per-channel noise estimates to said channel SNR estimation means;

valley detection means (570) for periodically detecting the minima of an overall estimate of the energy of said post-processed signal in each of a plurality of selected frequency bands, thereby generating a valley detect signal; and

signal controlling means (575) coupled to said storage means and controlled by said valley detect signal for providing new background noise estimates to said storage means only during said minima.

6. The improved noise suppression system according to claim 5, wherein said storage means (580, 585) includes:

smoothing means (580) for providing a time-averaged value of each of said background noise energy estimates of the pre-processed signal in a particular frequency band; and

memory means (585) for storing each of said time-averaged values from said smoothing means as per-channel noise estimates.

7. The improved noise suppression system according to claim 5, wherein said valley detection means (570) includes:

means for storing the numerical value of the previous detected minima as a previous valley level;

means for comparing the present numerical value of the overall energy estimate to said previous valley level;

means for increasing said previous valley level at a slow rate when said present numerical value is greater than said previous valley level; and

means for decreasing said previous valley level at a rapid rate when said present numerical value is less than said previous valley level, thereby updating said previous valley level to provide a current valley level.

8. The improved noise suppression system according to claim 3, wherein said channel gain controlling means (240) includes:

a plurality of gain tables (590), each gain table having predetermined individual channel gain values corresponding to various individual channel SNR estimates;

gain table selection means (555, 595) for automatically selecting one of said plurality of gain tables according to the overall average background noise level of said input signal;

whereby each individual channel gain value is selected as a function of (a) the individual channel number, (b) the current channel SNR estimate, and (c) the overall average background noise level.

**9.** The improved noise suppression system according to claim 3, wherein said channel gain controlling means (240) further includes:

gain smoothing means (530) for smoothing the gain values provided by said channel gain controlling means to said channel gain modifying means.

**Patentansprüche**

**1.** Verbessertes Geräuschunterdrückungssystem (400) zur Dämpfung des Hintergrundgeräuschs von einem geräuschbelasteten Eingabesignal (205), um ein gerauschvermindertes Ausgabesignal (265) zu erzeugen, wobei das Geräuschunterdrückungssystem besitzt:

Einrichtung (210) zum Teilen des Eingangssignals in eine Mehrzahl vorverarbeiteter Signale (215), die ausgewählte Frequenzkanäle darstellen,

Einrichtung (250) zum Modifizieren der Verstärkung von jedem der Mehrzahl vorverarbeiteter Signale als Reaktion auf einen vorbestimmten Verstärkungswert (245), um eine Mehrzahl nachverarbeiteter Signale (255) bereitzustellen,

Einrichtung (260) zum Kombinieren der Mehrzahl nachverarbeiteter Signale, um das geräuschverminderte Ausgabesignal zu erzeugen, und

Einrichtung (240, 310, 420) zum Erzeugen des vorbestimmten Verstärkungswerts, das Geräuschunterdrückungssystem *dadurch gekennzeichnet,* daß:

der vorbestimmte Verstärkungswert (245) als Reaktion auf Schätzungen des Signal-zu-Geräusch-Verhältnisses (SNR) in jedem einzelnen Kanal (235) erzeugt wird; und

die SNR-Schätzungen in jedem einzelnen Kanal auf der momentanen Signalenergieschätzung des vorverarbeiteten Signals in jedem einzelnen Kanal (225) und der vorangehenden Geräuschenergieschätzung des vorverarbeiteten Signals in jedem einzelnen Kanal (325) basieren, bestimmt zu Zeitpunkten, die den ermittelten Minima einer Darstellung der Mehrzahl nachverarbeiteter Signale entsprechen.

**2.** Verbessertes Geräuschunterdrückungssystem nach Anspruch 1, worin die Einrichtung zum Erzeugen der vorbestimmten Verstärkungswerte umfaßt:

eine Mehrzahl von Verstärkungstabellen (590), wobei jede Verstärkungstabelle vorbestimmte individuelle Kanalverstärkungswerte entsprechend den verschiedenen individuellen Kanal-SNR-Schätzungen besitzt; und

Verstärkungstabellenauswahleinrichtung (555, 595) zum automatischen Auswählen einer aus der Mehrzahl von Verstärkungstabellen entsprechend dem gesamten mittleren Hintergrundgeräuschpegel des Eingabesignals.

**3.** Verbessertes Geräuschunterdrückungssystem (500) zur Dämpfung des Hintergrundgeräuschs von einem geräuschbelasteten vorverarbeiteten Eingabesignal (205), um ein geräuschvermindertes nachverarbeitetes Ausgabesignal (265) durch spektrale Verstärkungsmodifizierung zu erzeugen, wobei das Geräuschunterdrückungssystem umfaßt:

Signalteilungseinrichtung (210) zum Teilen des vorverarbeiteten Eingabesignals in eine Mehrzahl ausgewählter Frequenzbänder, um dadurch eine Mehrzahl vorverarbeiteter Kanäle (215) zu erzeugen;

Kanalenergieschätzeinrichtung (220) zum Erzeugen einer Schätzung (225) der Energie in jedem der Mehrzahl vorverarbeiteter Kanäle;

Hintergrundgeräuschschätzeinrichtung (420) zum Erzeugen und Speichern von Schätzungen (325) der Hintergrundgeräuschenergie basierend auf den Kanalenergieschätzungen und zum periodischen Ermitteln der Minima des nachverarbeiteten Signalenergiepegels derartig, daß die Hintergrundgeräuschschätzungen nur während der Minima aktualisiert werden;

Kanal-SNR-Schätzeinrichtung (310) zum Erzeugen einer Schätzung des Signal-zu-Geräusch-Verhältnisses (SNR) jedes einzelnen Kanals (235) basierend auf den Kanalenergieschätzungen und den Hintergrundgeräuschschätzungen;

Kanalverstärkungssteuereinrichtung (240) zum Bereitstellen von Kanalverstärkungswerten (245) entsprechend den Kanal-SNR-Schätzungen;

Kanalverstärkungsmodifizierungseinrichtung (250) zum Einstellen der Verstärkung jedes der Mehrzahl der von der Signalteilungseinrichtung bereitgestellten vorverarbeiteten Kanäle entsprechend den Kanalverstärkungswerten, um dadurch eine Mehrzahl nachverarbeiteter Kanäle (255) zu erzeugen; und

Kanalkombinierungseinrichtung (260) zum Rekombinieren der Mehrzahl nachverarbeiteter Kanäle, um das nachbearbeitete Ausgabesignal zu erzeugen.

4. Verbessertes Geräuschunterdrückungssystem nach Anspruch 3, worin die Hintergrundgeräuschschätzeinrichtung (420) Einrichtung (560) zum Erzeugen der Darstellung des nachverarbeiteten Signalenergiepegels durch Multiplizieren der Mehrzahl vorverarbeiteter Kanäle mit den Kanalverstärkungswerten enthält.

5. Verbessertes Geräuschunterdrückungssystem nach Anspruch 3, worin die Hintergrundgeräuschschätzeinrichtung (420) umfaßt:

Speichereinrichtung (580, 585) zum Speichern einer Schätzung der Hintergrundgeräuschenergie des vorverarbeiteten Signals in jedem der Mehrzahl ausgewählter Frequenzbänder als pro-Kanal-Geräuschschätzungen und zum ständigen Bereitstellen der pro-Kanal-Geräuschschätzungen an die Kanal-SNR-Schätzeinrichtung;

Talermittlungseinrichtung (570) zum periodischen Ermitteln der Minima einer Gesamtschätzung der Energie des nachverarbeiteten Signals in jedem der Mehrzahl ausgewählter Frequenzbänder, um dadurch ein Talerkennungssignal zu erzeugen; und

Signalsteuereinrichtung (575), verbunden mit der Speichereinrichtung und gesteuert durch das Talerkennungssignal, zum Bereitstellen neuer Hintergrundgeräuschschätzungen an die Speichereinrichtung nur während der Minima.

6. Verbessertes Geräuschunterdrückungssystem nach Anspruch 5, worin die Speichereinrichtung (580, 585) umfaßt:

Glättungseinrichtung (580) zum Bereitstellen eines zeitgemittelten Werts jeder der Hintergrundgeräuschenergieschätzungen des vorverarbeiteten Signals in einem einzelnen Frequenzband; und

Speichereinrichtung (585) zum Speichern jedes der zeitgemittelten Werte von der Glättungseinrichtung als pro-Kanal-Geräuschschätzungen.

7. Verbessertes Geräuschunterdrückungssystem nach Anspruch 5, worin die Talermittlungseinrichtung (570) umfaßt:

Einrichtung zum Speichern des numerischen Werts der vorangehenden ermittelten Minima als ein vorangehender Talpegel;

Einrichtung zum Vergleichen des momentanen numerischen Werts der Gesamtenergieschätzung mit dem vorangehenden Talpegel;

Einrichtung zum Erhöhen des vorangehenden Talpegels mit einer langsamen Geschwindigkeit, wenn der momentane numerische Wert größer als der vorangehende Talpegel ist; und

Einrichtung zum Vermindern des vorangehenden Talpegels mit einer schnellen Geschwindigkeit, wenn der momentane numerische Wert kleiner als der vorangehende Talpegel ist, um damit den vorangehenden Talpegel zu aktualisieren, um einen momentanen Talpegel bereitzustellen.

8. Verbessertes Geräuschunterdrückungssystem nach Anspruch 3, worin die Kanalverstärkungssteuereinrichtung (240) umfaßt:

eine Mehrzahl von Verstärkungstabellen (590), jede Verstärkungstabelle mit vorbestimmten individuellen Kanalverstärkungswerten entsprechend den verschiedenen individuellen Kanal-SNR-Schätzungen;

Verstärkungstabellenauswahleinrichtung (555, 595) zum automatischen Auswählen einer aus der Mehrzahl von Verstärkungstabellen entsprechend dem gesamten mittleren Hintergrundgeräuschpegel des Eingabesignals;

womit jeder einzelene Kanalverstärkungswert als eine Funktion von (a) der einzelnen Kanalnummer, (b) der momentanen Kanal-SNR-Schätzung und (c) des gesamten mittleren Hintergrundgeräuschpegels ausgewählt wird.

9. Verbessertes Geräuschunterdrückungssystem nach Anspruch 3, worin die Kanalverstärkungssteuereinrichtung (240) weiter umfaßt:

Verstärkungsglättungseinrichtung (530) zum Glätten der von der Kanalverstärkungssteuereinrichtung an die Kanalverstärkungsmodifizierungseinrichtung bereitgestellten Verstärkungswerte.

## Revendications

1. Système éliminateur de bruit perfectionné (400) destiné à atténuer le bruit de fond dans un signal d'entrée bruyant (205) afin de produire un signal de sortie à bruit éliminé (265), ledit système

EP 0 226 613 B1

éliminateur de bruit comportant :

un moyen (210) pour séparer le signal d'entrée en une pluralité de signaux pré-traités (215) représentatifs de canaux de fréquence sélectionnés ;

un moyen (250) pour modifier le gain de chacun de ladite pluralité de signaux pré-traités en réponse à une valeur de gain prédéterminée (245) afin de produire une pluralité de signaux post-traités (255) ;

un moyen (260) pour combiner ladite pluralité de signaux post-traités afin de produire ledit signal de sortie à bruit éliminé : et

un moyen (240, 310, 420) pour produire ladite valeur de gain prédéterminée,

ledit système éliminateur de bruit étant caractérisé en ce que :

ladite valeur de gain prédéterminée (245) est produite en réponse à des estimations du rapport signal sur bruit (SNR) dans chaque canal individuel (235) ; et

lesdits SNR estimés dans chaque canal individuel sont basés sur l'estimation d'énergie de signal courante du signal pré-traité dans chaque canal individuel (225) et sur l'estimation d'énergie de bruit précédente du signal pré-traité dans chaque canal individuel (325) déterminées pour des moments correspondant aux minima détectés d'une représentation de ladite pluralité de signaux post-traités.

2. Système éliminateur de bruit perfection né selon la revendication 1, dans lequel ledit moyen pour produire ladite valeur de gain prédéterminée inclut :

une pluralité de tables de gains (590), chaque table de gains comportant des valeurs de gain de canal individuel prédéterminées correspondant à diverses estimations de SNR de canal individuel ; et

un moyen de sélection de table de gains (555, 595) pour sélectionner automatiquement l'une de ladite pluralité de tables de gains conformément au niveau de bruit de fond moyen global dudit signal d'entrée.

3. Système éliminateur de bruit perfectionné (500) pour atténuer le bruit de fond dans un signal d'entrée pré-traité bruyant (205) afin de produire un signal de sortie post-traité à bruit éliminé (265) au moyen d'une modification de gain spectrale, ledit système éliminateur de bruit comprenant :

un moyen de division de signal (210) pour séparer le signal d'entrée pré-traité en une pluralité de bandes de fréquence sélectionnées pour ainsi produire une pluralité de canaux pré-traités (215) ;

un moyen d'estimation d'énergie de canal (220) pour générer une estimation (225) de l'énergie dans chacun de ladite pluralité de canaux pré-traités ;

un moyen d'estimation de bruit de fond (420) pour générer et stocker des estimations (325) de l'énergie de bruit de fond sur la base desdites estimations d'énergie de canal et pour détecter périodiquement les minima du niveau d'énergie du signal post-traité de telle sorte que lesdites estimations de bruit de fond soient mises à jour seulement pendant lesdits minima ;

un moyen d'estimation de SNR de canal (310) pour générer une estimation du rapport signal sur bruit (SNR) de chaque canal individuel (235) sur la base desdites estimations d'énergie de canal et desdites estimations de bruit de fond ;

un moyen de commande de gain de canal (240) pour produire des valeurs de gain de canal (245) correspondant auxdites estimations de SNR de canal ;

un moyen de modification de gain de canal (250) pour régler le gain de chacun de ladite pluralité de canaux pré-traités produits par ledit moyen de division de signal conformément auxdites valeurs de gain de canal pour ainsi produire une pluralité de canaux post-traités (255) ; et

un moyen de combinaison de canaux (260) pour recombiner ladite pluralité de canaux post-traités afin de produire ledit signal de sortie post-traité.

4. Système éliminateur de bruit perfectionné selon la revendication 3, dans lequel ledit moyen d'estimation de bruit de fond (420) inclut un moyen (560) pour générer ladite représentation du niveau d'énergie de signal post-traité en multipliant ladite pluralité de canaux pré-traités par lesdites valeurs de gain de canal.

5. Système éliminateur de bruit perfectionné selon la revendication 3, dans lequel ledit moyen d'estimation de bruit de fond (420) inclut :

un moyen de stockage (580, 585) pour stocker une estimation de l'énergie de bruit de fond du signal pré-traité dans chacune de ladite pluralité de bandes de fréquence sélectionnées en tant qu'estimations de bruit par canal et pour produire en continu lesdites estimations de bruit par canal pour ledit moyen d'estimation de SNR de canal ;

17

un moyen de détection de vallée (570) pour détecter périodiquement les minima d'une estimation globale de l'énergie dudit signal post-traité dans chacune d'une pluralité de bandes de fréquence sélectionnées pour ainsi générer un signal de détection de vallée ; et

un moyen de commande de signal (575) coupé audit moyen de stockage et commandé par ledit signal de détection de vallée pour produire de nouvelles estimations de bruit de fond pour ledit moyen de stockage seulement pendant lesdits minima.

6. Système éliminateur de bruit perfectionné selon la revendication 5, dans lequel ledit moyen de stockage (580, 585) inclut :

un moyen de lissage (580) pour produire une valeur moyennée dans le temps de chacune desdites estimations d'énergie de bruit de fond du signal pré-traité dans une bande de fréquence particulière ; et

un moyen de mémoire (585) pour stocker chacune desdites valeurs moyennées dans le temps en provenance dudit moyen de lissage en tant qu'estimations de bruit par canal.

7. Système éliminateur de bruit perfectionné selon la revendication 5, dans lequel ledit moyen de vallée (570) inclut :

un moyen pour stocker la valeur numérique des minima détectés précédemment en tant que niveau de vallée précédent ;

un moyen pour comparer la valeur numérique présente de l'estimation d'énergie globale audit niveau de vallée précédent ;

un moyen pour augmenter ledit niveau de vallée précédent selon une vitesse lente lorsque ladite valeur numérique présente est supérieure audit niveau de vallée précédent et

un moyen pour diminuer ledit niveau de vallée précédent selon une vitesse rapide lorsque ladite valeur numérique présente est inférieure audit niveau de vallée précédent, d'où la mise à jour dudit niveau de vallée précédent pour produire un niveau de vallée courant.

8. Système éliminateur de bruit perfectionné selon la revendication 3, dans lequel ledit moyen de commande de gain de canal (240) inclut :

une pluralité de tables de gains (590), chaque table de gains comportant des valeurs de gain de canal individuel prédéterminées correspondant à diverses estimations de SNR de canal individuel ;

un moyen de sélection de table de gains (555, 595) pour sélectionner automatiquement l'une de ladite pluralité de tables de gains conformément au niveau de bruit de fond moyen global dudit signal d'entrée,

d'où il résulte que chaque valeur de gain de canal individuel est sélectionnée en fonction (a) du numéro de canal individuel, (b) de l'estimation de SNR de canal courante et (c) du niveau de bruit de fond moyen global.

9. Système éliminateur de bruit perfection né selon la revendication 3, dans lequel ledit moyen de commande de gain de canal (240) inclut en outre :

un moyen de lissage de gain (530) pour lisser les valeurs de gain produites par ledit moyen de commande de gain de canal pour ledit moyen de modification de gain de canal.

PRIOR ART

Fig. 1

EP 0 226 613 B1

PRE-PROCESSED SPEECH

POST-PROCESSED SPEECH

SPEECH AND NOISE SIGNAL IN

205

CHANNEL DIVIDER 210

200

215

CHANNEL GAIN MODIFIER 250

255

CHANNEL COMBINER 260

SPEECH SIGNAL OUT 265

CHANNEL ENERGY ESTIMATOR 220

225

CHANNEL NOISE ESTIMATOR 230

235

CHANNEL GAIN CONTROLLER 240

245

PRIOR ART

*Fig. 2*

EP 0 226 613 B1

Fig. 3

Fig. 4

EP 0 226 613 B1

**Fig. 5**

EP 0 226 613 B1

INITIALIZATION — 601

INCREMENT SAMPLE — 602

INPUT SAMPLE — 603

— 604

PRE-EMPHASIZE — 605

SET CHANNEL = 1 — 606

ALL CHANNELS ? — 607 — YES

— 611 INCREMENT CHANNEL

NO — 608

ESTIMATE ENERGY — 608

SMOOTH GAIN — 609

MODIFY SPECTRUM — 610

DE-EMPHASIZE — 612

OUTPUT SAMPLE — 613

ALL SAMPLES ? — 614 — NO

YES

A

B

Fig. 6a

*Fig. 6b*

*Fig. 7a*

FROM 603

```
                    ┌──────────────────────┐ ⌐701
                    │    PRE-EMPHASIZE     │
                    │  INPUT SPEECH SAMPLE │
                    └──────────────────────┘

                    ┌──────────────────────┐ ⌐702
                    │  CC = 1 , TOTAL = 0  │
                    └──────────────────────┘

                         703
                        CC=N    YES
                         ?
                        NO

                    ┌──────────────────────┐ ⌐704
                    │   FILTER SAMPLE WITH  │
                    │   BANDPASS FILTER CC  │
                    └──────────────────────┘

                    ┌──────────────────────┐ ⌐705
                    │   FULL-WAVE RECTIFY   │
                    │    CHANNEL SAMPLE     │
                    └──────────────────────┘

                    ┌──────────────────────┐ ⌐706
                    │    LOWPASS FILTER     │
                    │    CHANNEL SAMPLE     │
                    └──────────────────────┘

                    ┌──────────────────────┐ ⌐707
                    │ STORE CHANNEL ESTIMATE│
                    └──────────────────────┘

                    ┌──────────────────────┐ ⌐708
                    │  SMOOTH RAW GAIN VALUE│
                    │    FOR CHANNEL CC     │
                    └──────────────────────┘

                    ┌──────────────────────┐ ⌐709
                    │ MULTIPLY FILTER SAMPLE│
                    │BY SMOOTHED GAIN VALUE │
                    │    FOR CHANNEL CC     │
                    └──────────────────────┘

                    ┌──────────────────────┐ ⌐710
                    │  ADD CHANNEL (CC) SAMPLE│
                    │ TO OUTPUT SAMPLE TOTAL│
                    └──────────────────────┘

                    ┌──────────────────────┐ ⌐711
                    │      CC = CC + 1      │
                    └──────────────────────┘

                    ┌──────────────────────┐ ⌐712
                    │    DE-EMPHASIZE      │
                    │ OUTPUT SPEECH SAMPLE │
                    └──────────────────────┘

                         TO 613
```

*Fig. 7b*

FROM 614

CC = 1    720

CC=N ?    721    YES

NO

CALCULATE SNR FOR CHANNEL CC    722

QUANTIZE CURRENT VALLEY LEVEL    723

CHOOSE GAIN TABLE PER QUANTIZATION VALUE    724

INDEX GAIN TABLE PER SNR AND CHANNEL CC    725

OBTAIN RAW GAIN VALUE    726

STORE RAW GAIN VALUE FOR CHANNEL CC    727

CC = CC + 1    728

TO 621

FROM 615

SET CHANNEL
COUNT(CC) TO 1 — 730

DONE
WITH ALL
N CHANNELS
? — 731 — YES

*Fig. 7c*

NO

SIM POST-PROCESSED ENERGY
FOR CHANNEL CC=RAW GAIN VALUE
FOR CHANNEL CC X PRE-PROCESSED
ENERGY EST. FOR CHANNEL CC — 732

INCREMENT CC — 733

SET CHANNEL
COUNT (CC) TO 1 — 734

INITIALIZE POST-
PROCESSED
ENERGY TO ZERO — 735

DONE
WITH ALL
N CHANNELS
? — 736 — YES → TO 740

NO

ENERGY=ENERGY PLUS SIM.
POST-PROCESSED ENERGY
OF CHANNEL CC — 737

INCREMENT CC — 738

28

FROM 736

COMPUTE LOG OF COMBINED POST-PROCESSED CHANNEL ENERGY — 740

IS LOG (POST-PROC ENERGY)>PREVIOUS VALLEY LEVEL ? — 741

NO

YES

DECREASE VALLEY 40 MS. TC

742

INCREASE VALLEY 1 SEC. TC — 743

IS LOG (POST-PROC ENERGY) > VALLEY PLUS OFFSET ? — 744

YES

NO

UPDATE NOISE SPECTRAL ESTIMATE — 745

TO 629

*Fig. 7d*

29